# EUROPÄISCHE PATENTSCHRIFT

(11) **EP 4 248 825 B1**
(45) Veröffentlichungstag und Bekanntmachung des Hinweises auf die Patenterteilung: **18.11.2026**
(21) Anmeldenummer: 23191988.7
(22) Anmeldetag: 31.01.2019
(51) Int. Cl.: H02J 7/00, A47L 9/28

(54) **AKKU-BETRIEBENES HAUSHALTSGERÄT UND AKKU-LADESTATION**
BATTERY-OPERATED DOMESTIC APPLIANCE AND BATTERY CHARGING STATION
APPAREIL ÉLECTROMÉNAGER FONCTIONNANT SUR UN ACCUMULATEUR ET STATION DE CHARGE D'ACCUMULATEUR

(43) Veröffentlichungstag der Anmeldung: 27.09.2023
(62) Dokumentnummer(n) der früheren Anmeldung(en) nach Art. 76 EPÜ: 19154796.7 / 3 691 074
(73) Patentinhaber: Vorwerk & Co. Interholding GmbH, 42275 Wuppertal (DE)
(72) Erfinder: Arnold, Hans-Peter, 58566 Kierspe (DE); Büning, Thomas, 44795 Bochum (DE); Fleczok, Benjamin, 45144 Essen (DE); Frielinghaus, Robert, 44803 Bochum (DE); Helmich, Martin, 47055 Duisburg (DE); Hillen, Lorenz, 42287 Wuppertal (DE); Holz, Christian, 44137 Dortmund (DE); Isenberg, Gerhard, 50668 Köln (DE); Mosebach, Andrej, 44809 Bochum (DE); Ortmann, Roman, 47057 Duisburg (DE); Schmitz, Kevin, 42781 Haan (DE); Vitz, Fabian, 42327 Wuppertal (DE); Van Teeffelen, Niklas, 42549 Velbert (DE); Hackert, Georg, 44869 Bochum (DE)
(74) Vertreter: Gille Hrabal Partnerschaftsgesellschaft mbB Patentanwälte

(56) Entgegenhaltungen:
- CA-A1- 2 383 445

## Beschreibung

Die Erfindung betrifft ein System mit einem Haushaltsgerät, einer Ladestation und mehreren Akku-Einheiten sowie ein Haushaltsgerät und eine Ladeeinheit.

Haushaltsgeräte wie z.B. ein Akku-Staubsauger, die mit einem Akku betrieben werden, haben den Nachteil, dass die Benutzung durch die Akkulaufzeit begrenzt ist. Daher wird häufig ein Ersatz-Akku bereitgestellt, um den Benutzungsvorgang ohne größere Unterbrechung fortsetzen zu können. Wenn der sich im Betrieb befindliche Akku leer ist, kann der leere Akku sofort durch den vollgeladenen Ersatz-Akku ersetzt werden, der in einer Ladestation aufgeladen und in einem geladenen Zustand gehalten wurde. Der zuerst eingesetzte und nun entleerte Akku wird wiederum an die Ladestation zum Laden angeschlossen. Bei längeren Benutzungsvorgängen wie z.B. dem Saugen einer größeren Wohnung kann es vorkommen, dass der Ersatz-Akku leer ist, bevor der Benutzungsvorgang abgeschlossen ist. In diesem Fall wird der zuerst verwendete Akku der Ladestation entnommen, gegen den Ersatz-Akku im Haushaltsgerät ausgetauscht und der Ersatz-Akku wieder an die Ladestation zum Laden angeschlossen. Da in der Regel der zuerst verwendete Akku zu diesem Zeitpunkt nur teilweise geladen ist, wiederholt sich der oben beschriebene Akku-Austausch in immer kürzeren Zeitabständen, bis letztendlich beide Akkus nahezu leer sind und der Benutzungsvorgang abgebrochen werden muss, bis mindestens einer der Akkus wieder voll aufgeladen ist.

Derzeit wird dieses Problem beispielsweise dadurch gelöst, dass ein Notanschluss für ein Stromkabel an dem Haushaltsgerät vorgesehen ist. Hierdurch gehen jedoch die Vorteile des Akku-Betriebs, dass kein störendes Kabel und auch keine nahegelegene Steckdose benötigt wird, verloren. Eine andere Lösung besteht in dem Vorsehen einer größeren Anzahl von Ersatz-Akkus und entsprechenden Ladestationen für diese Ersatz-Akkus. Dies erhöht einerseits die Kosten und andererseits werden viele dieser Ersatz-Akkus überwiegend in einem vollgeladenen Zustand gehalten, was die Lebensdauer der Akkus reduziert. Wenn in einem besonders langen Benutzungsvorgang dann der letzte und nur selten eingesetzte Ersatz-Akku zum Einsatz kommt, ist dessen Akkulaufzeit häufig nur noch sehr gering.

Aufgrund der oben beschriebenen Problematik werden zunehmend Ladestationen eingesetzt, die ein sogenanntes Schnellladen ermöglichen, um die Ladezeit eines Akkus zu minimieren. Ein solches gegenüber einer normalen Ladegeschwindigkeit beschleunigtes Laden kann jedoch zu Beschädigungen des Akkus und zu einer geringeren Lebensdauer des Akkus führen. Dokument CA2383445A1 offenbart ein akkubetriebenes Haushaltsgerät, bei dem ein möglichst unterbrechungsfreier Betrieb sichergestellt werden kann.

Die vorgenannten, aus dem Stand der Technik bekannten Merkmale können einzeln oder in beliebiger Kombination mit einem der nachfolgend beschriebenen erfindungsgemäßen Gegenstände und Ausführungsformen kombiniert werden.

Es ist Aufgabe der Erfindung, eine verbesserte Lösung für das oben beschriebene Problem bereitzustellen.

Zur Lösung der Aufgabe dienen ein System gemäß dem Hauptanspruch sowie ein Haushaltsgerät und eine Ladestation gemäß den Nebenansprüchen. Vorteilhafte Ausführungsformen ergeben sich aus den Unteransprüchen.

Zur Lösung der Aufgabe dient ein System mit einem Haushaltsgerät, einer Ladestation und mehreren Akku-Einheiten. Das System umfasst eine Steuerung, die so konfiguriert ist, dass eine Akku-Einheit, die an die Ladestation angeschlossen ist, in Abhängigkeit von einer Entladung einer Akku-Einheit, die zum Betrieb des Haushaltsgeräts zur Durchführung eines Benutzungsvorgangs an das Haushaltsgerät angeschlossen ist, geladen werden kann.

Durch die Erfindung kann vorteilhaft erreicht werden, dass eine Akku-Einheit nur dann beschleunigt aufgeladen wird, wenn dies erforderlich ist, um das Haushaltgerät kontinuierlich benutzen zu können. Es ist also möglich, eine Akku-Einheit im Regelfall normal oder sogar langsam und damit besonders schonend aufzuladen. Vorteilhaft wird also nur dann beschleunigt aufgeladen, wenn sich eine nicht vollständig geladene Akku-Einheit in der Ladestation befindet und zeitgleich das Haushaltsgerät betrieben wird, also Strom verbraucht wird. Insgesamt kann so eine lange Lebensdauer der Akkus erreicht und gleichzeitig gezielt eine möglichst kontinuierliche Benutzung eines rein akkubetriebenen Haushaltsgerätes sichergestellt werden.

Die Einsatzbereitschaft des akku-betriebenen Haushaltsgerätes wird somit erhöht und eine quasi unendliche Benutzungsdauer des Haushaltsgeräts zur Durchführung eines Benutzungsvorgangs mit den Akku-Einheiten ermöglicht.

Eine quasi unendliche Benutzungsdauer meint einen grundsätzlich unbegrenzten, kontinuierlichen Betrieb des Haushaltsgeräts durch die Akku-Einheiten ohne unerwünschte Auflade-Pausen, sondern lediglich mit kurzen Unterbrechungen zum Austauschen der Akku-Einheiten. Es wird ermöglicht, mit nur zwei Akku-Einheiten oder zumindest mit einer deutlich reduzierten Anzahl von Akku-Einheiten sehr lange Benutzungsvorgänge ohne eine störende Unterbrechung zum Akku-Aufladen durchführen zu können und gleichzeitig eine möglichst lange Lebensdauer der Akku-Einheiten zu erzielen, die bei Erreichen des Endes der Lebensdauer zu erneuern sind.

Ein Haushaltsgerät kann dadurch auf eine Einrichtung zum Anschluss an ein externes Stromnetz verzichten. Insbesondere umfasst das System genau zwei oder drei Akku-Einheiten. Vorzugsweise ist das Haushaltsgerät so eingerichtet, dass das Haushaltsgerät ausschließlich durch eine Akku-Einheit mit elektrischer Energie zum Betrieb des Haushaltsgeräts versorgt werden kann. Optional kann ein Anschluss an ein externes Stromnetz vorgesehen werden, um eine Akku-Einheit zu laden, die an das Haushaltsgerät angeschlossen ist. In einer Ausgestaltung ist eine Basisstation für das Haushaltsgerät vorgesehen. Eine an das Haushaltsgerät angeschlossene Akku-Einheit kann dann durch Anschließen des Haushaltsgeräts an die Basisstation geladen werden. Die Basisstation ist an ein externes Stromnetz angeschlossen. In einer Ausgestaltung umfasst die Basisstation eine Basisstationssteuerung.

Ein Haushaltsgerät ist beispielsweise ein Reinigungsgerät für den Haushalt, ein Speisenzubereitungsgerät für den Haushalt, eine Nähvorrichtung für den Haushalt oder ein Werkzeug für den Heimhandwerker wie ein Akku-Schrauber für den Haushalt. Ein Benutzungsvorgang ist beispielsweise das Reinigen einer Wohnung oder des Bodens einer Wohnung, eine automatisch oder teilautomatische Speisenzubereitung einer Speise oder eines Getränks oder ein häuslicher Reparatur- oder Errichtungsvorgang. Ein Benutzungsvorgang ist ein durchgängiger Vorgang. Ein Benutzungsvorgang kann durch eine Pause unterbrochen werden, die jedoch nicht durch entleerte Akkus verursacht worden ist.

Eine Ladestation ist ein von dem Haushaltsgerät separates Gerät zum Aufladen einer Akku-Einheit, die an die Ladestation angeschlossen ist. Die Ladestation ist an ein externes Stromnetz angeschlossen. Ein externes Stromnetz stellt z.B. über eine Steckdose elektrische Energie bereit, die über ein Stromkabel geleitet werden kann. In einer Ausgestaltung umfasst die Ladestation eine Ladestationssteuerung.

Eine Akku-Einheit kann ein einzelner Akku oder ein Akku-Pack mit mehreren Akkus sein. Eine Akku-Einheit zum Betrieb des Haushaltsgeräts kann das Haushaltsgerät mit elektrischer Energie versorgen. In einer Ausgestaltung umfasst die Akku-Einheit eine Akkueinheitssteuerung, insbesondere ein sogenanntes Batterie-Management-System (BMS). Eine an das Haushaltsgerät bzw. die Ladestation angeschlossene Akku-Einheit kann auch als eine Akku-Einheit des Haushaltsgeräts bzw. Akku-Einheit der Ladestation bezeichnet werden. Eine Akkulaufzeit ist die maximal mögliche Zeitdauer, innerhalb der eine an das Haushaltsgerät angeschlossene Akku-Einheit das Haushaltsgerät mit elektrischer Energie versorgen kann, wobei zur Vergleichbarkeit von Akkulaufzeiten eine konstante Referenzleistung des Haushaltsgeräts zugrunde gelegt wird. Eine entladene, leere oder entleerte Akku-Einheit liegt dann vor, wenn eine definierte Entladeuntergrenze erreicht ist. Eine vollgeladene Akku-Einheit liegt vor, wenn der Ladezustand einer definierten Ladeobergrenze entspricht. Sowohl die Entladeuntergrenze als auch die Ladeobergrenze sind grundsätzlich nicht die äußersten technisch verfügbaren Unter- und Obergrenzen, sondern entsprechen den Herstellerangaben zum Schutz der Akku-Einheit oder werden in einer Ausgestaltung zwischen der Obergrenze und Untergrenze gemäß Herstellerangabe durch die Steuerung festgelegt. Insbesondere sind die Akku-Einheiten baugleich. Vorzugsweise weist das System genau zwei oder genau drei Akku-Einheiten auf. Grundsätzlich können eine weitere Akku-Einheit oder mehrere weitere Akku-Einheiten vorgesehen werden, beispielsweise bei Benutzungsvorgängen oder Haushaltsgeräten mit besonders hohem Leistungsbedarf. Die Lebensdauer eines Akkus bezieht sich auf die maximal verfügbare Kapazität oder die Anzahl der Lade- und Entladezyklen vom Auslieferungszustand des Akkus bis zu einem Ende der Lebensdauer. Das Ende der Lebensdauer ist beispielsweise dann erreicht, wenn nur noch eine technisch maximal verfügbare Kapazität von 80% verglichen mit dem Auslieferungszustand vorhanden ist oder eine vorgegebene Anzahl von z.B. tausend Lade-/Entladezyklen erreicht ist. Ein Maß für die maximal verfügbare Kapazität kann ermittelt werden, indem der Akku - ohne eine beschränkende Einwirkung einer Steuerung - maximal aufgeladen wird und das Haushaltsgerät eingeschaltet und die Zeit gemessen wird, bis das Haushaltsgerät seinen Betrieb infolge einer Entleerung der Akku-Einheit einstellt. Mit dem Alter einer Akku-Einheit nimmt die maximal verfügbare Kapazität (im Folgenden kurz "Ladekapazität" genannt) infolge von Alterungserscheinungen ab. Der Ladezustand gibt an, wie viel Prozent der maximal verfügbaren Kapazität aktuell geladen sind und folglich zur Verfügung stehen.

Die Entladung ist eine Variable, die mit einem Zahlenwert angegeben werden kann. Ein Laden in Abhängigkeit von einer Entladung einer Akku-Einheit bedeutet, dass die Steuerung einen Algorithmus umfasst, der eine Eingangsgröße, der die Entladung angibt, in eine Ausgangsgröße, die zum Steuern des Ladevorgangs verwendet wird, umwandelt.

Erfindungsgemäß ist die Steuerung so konfiguriert, dass die Akku-Einheit der Ladestation, die an die Ladestation angeschlossen ist, in einem Ladungsumfang geladen werden kann, die der Entladung der Akku-Einheit des Haushaltsgeräts, die zum Betrieb des Haushaltsgeräts zur Durchführung eines Benutzungsvorgangs an das Haushaltsgerät angeschlossen ist, entspricht. Das bedeutet, dass nach einem Ersetzen der Akku-Einheiten die mit diesem Ladungsumfang geladene Akku-Einheit in einem gleichen Umfang entladen werden kann, wie zuvor die ersetzte Akku-Einheit. Erfindungsgemäß beinhaltet der Ladungsumfang eine Verlustkompensation.

Die Entladung ist ein Absolutwert größer Null. Die beiden Akku-Einheiten verhalten sich z.B. bezogen auf die elektrische Leistung oder die Änderung des Ladezustands entgegengesetzt.

Eine Verlustkompensation ist ein Wert größer Null zur Kompensation von energetischen Verlusten, die auftreten können. Wenn die Akku-Einheit des Haushaltsgeräts um eine bestimmte Energie entladen wird, im Gegenzug die Akku-Einheit der Ladestation um dieselbe bestimmte Energie geladen wird und schließlich die Akku-Einheit des Haushaltsgeräts durch die Akku-Einheit der Ladestation ersetzt wird, kann aufgrund energetischer Verluste über diesen gesamten Prozess eine Differenz entstehen. Wird beispielsweise eine Akku-Einheit eines Staubsaugers als das Haushaltsgerät durch den Benutzungsvorgang mit z.B. 400 W entladen und wird die Akku-Einheit der Ladestation ebenfalls mit 400 W aufgeladen, so können nach dem Austauschen der Akku-Einheiten insgesamt Leistungsverluste von z.B. 100 W entstehen. Durch das Vorsehen der Verlustkompensation, in dem benannten Beispiel in Höhe von 100W, kann eine zeitlich unbegrenzte Benutzungsdauer besonders zuverlässig ermöglicht werden. Insbesondere ist die Verlustkompensation eine Verlustleistungskompensation. Erfindungsgemäß ist die Verlustkompensation als ein festgelegter Parameter, bevorzugt als Anteil der Entladung, in der Steuerung hinterlegt und/oder wird auf Basis von Messungen während aktueller oder vergangener Benutzungsvorgänge bevorzugt durch die Steuerung ermittelt. In einer Ausgestaltung wird die Verlustkompensation z.B. in Abhängigkeit von der aktuellen Ladekapazität, des aktuellen Innenwiderstands, des aktuellen Ladezustands und/oder des Typs der Akku-Einheit des Haushaltsgeräts bzw. der Ladestation ermittelt oder aus hinterlegten Parameterwerten entsprechend ausgewählt, z.B. via Lookup-Tabelle. Optional kann die Umgebungstemperatur und/oder eine Haushaltsgeräteeinstellung wie z.B. die aktuelle Leistungsstufe eines Staubsaugers bei der Ermittlung der Verlusttemperatur berücksichtigt werden.

In einer Ausführungsform ist die Steuerung so konfiguriert, dass die Akku-Einheit der Ladestation bis zur Entleerung der Akku-Einheit des Haushaltsgerätes in einem Ladungsumfang geladen werden kann, die der Entladung der Akku-Einheit während der Durchführung des Benutzungsvorgangs entspricht oder die gleich der Entladung der Akku-Einheit während der Durchführung des Benutzungsvorgangs zuzüglich einer Verlustkompensation ist. Der Ladungsumfang ist also ein benötigter Ladungsumfang in Abhängigkeit von der Entladung und gegebenfalls einem Verlust. Wenn die Akku-Einheit der Ladestation bereits nahezu voll geladen ist, wird entsprechend langsam geladen, und wenn die Akku-Einheit entleert ist, entsprechend schnell geladen. Die Lebensdauer der Akku-Einheiten kann hierdurch verlängert werden. Nachdem die Akku-Einheit der Ladestation die entleerte Akku-Einheit des Haushaltsgerätes ersetzt hat, kann der Benutzer mit einer Akkulaufzeit ungefähr wie bei der zuvor ersetzten Akku-Einheit mit der Durchführung des Benutzungsvorgangs fortfahren. Vorteilhaft kann ein Benutzer also die Akkulaufzeit einschätzen. In einer Ausgestaltung ist der Ladezeitraum der (Ersatz-)Akku-Einheit gleich dem Entladezeitraum der zu ersetzenden Akku-Einheit.

In einer Ausführungsform kann die Ladestation mit zwei verschiedenen Ladegeschwindigkeiten, vorzugsweise mit drei oder vier verschiedenen Ladegeschwindigkeiten, laden werden. Insbesondere kann langsam, normal oder beschleunigt geladen werden. Beschleunigt laden meint ein Laden mit sehr oder übermäßig hoher Ladegeschwindigkeit, die größer ist als normal. Beschleunigtes Laden ist in einer Ausgestaltung ein Laden, dass mit dem Fachbegriff "Schnellladen" bezeichnet wird. Laden mit normaler Ladegeschwindigkeit bezieht sich in einer Ausgestaltung auf eine standardmäßige Ladegeschwindigkeit, also kein "Schnellladen". Durch das Vorsehen mehrerer Ladegeschwindigkeiten Dies ermöglicht, die Ladegeschwindigkeit der Akku-Einheit der Ladestation an die Entladegeschwindigkeit der zeitgleich sich im Betrieb befindlichen Akku-Einheit des Haushaltsgeräts anzupassen, bevorzugt unter Berücksichtigung einer Verlustkompensation. Außerdem kann ansonsten mit langsamer Ladegeschwindigkeit, also mit einer niedrigeren Geschwindigkeit als der normalen Ladegeschwindigkeit, geladen werden. Das Vorsehen zusätzlicher Akku-Einheiten, die sonst erforderlich gewesen wären, kann so vermieden werden. Technisch bedingt kann es bei einer theoretisch gleichen Geschwindigkeit zu Abweichungen von z.B. bis zu zehn Prozent kommen. Die verschiedenen Ladegeschwindigkeiten können in Abhängigkeit von der Akku-Einheit und/oder dem Akku-Typ unterschiedlich festgelegt sein.

In einer Ausgestaltung ist das System so konfiguriert, dass bei unterschiedlichen Ladekapazitäten bei ansonsten gleichen Akku-Einheiten nur die Akku-Einheit mit der größeren Ladekapazität - die also in der Regel weniger gealtert ist - mit maximal möglicher Geschwindigkeit bzw. beschleunigt geladen wird. Da bei stärker gealterten Akku-Einheiten ein beschleunigtes Laden zu einer überproportional größeren Reduzierung der weiteren Lebensdauer führt als bei weniger stark gealterten Akku-Einheiten, kann dadurch eine einheitliche Lebensdauer der verwendeten Akku-Einheiten erreicht werden. Es wird so die Situation vermieden, dass nur eine Akku-Einheit zur Verfügung steht oder die Anschaffung einer neuen Akku-Einheit dazu führt, mit unterschiedlich funktionsfähigen Akkus das Haushaltsgerät betreiben zu müssen.

In einer Ausführungsform sind die Ladestation und die Akku-Einheit so eingerichtet, dass beschleunigt geladen werden kann, derart, dass die Akku-Einheit der Ladestation stufenlos oder zumindest quasi stufenlos mit dem benötigten Ladungsumfang geladen werden kann. Es kann dann also mit einer Ladegeschwindigkeit geladen werden, die gerade ausreicht, um den benötigten Ladungsumfang während des Ladens der Akku-Einheit der Ladestation zu erreichen. Die Lebensdauer der Akku-Einheiten kann so besonders wirkungsvoll verlängert werden.

Der benötigte Ladungsumfang ist ein Absolutwert in Höhe der Entladung insbesondere zuzüglich der Verlustkompensation. Dies vermeidet ein unnötiges Laden mit einer maximal möglichen Ladegeschwindigkeit.

In einer Ausführungsform wird die Entladung ermittelt, indem die durch das Haushaltsgerät verbrauchte elektrische Leistung, d.h., Entladeleistung, der Akku-Einheit des Haushaltsgerätes ermittelt wird. Die Entladung kann so sehr einfach ermittelt werden. Die elektrische Leistung bzw. Entladeleistung ist das Produkt aus Stromstärke und Spannung, welche dem Haushaltsgerät von einer Akku-Einheit zum Durchführen eines Benutzungsvorgangs geliefert wird. In einer Ausgestaltung wird die Entladeleistung von der Haushaltsgerätesteuerung oder der Akkueinheitssteuerung gemessen oder ermittelt. Alternativ oder ergänzend kann die Entladung anhand oder unter Berücksichtigung von einer gemessenen Stromstärke, einer gemessenen Spannung, einer insgesamt entnommenen Energiemenge, einem Innenwiderstand und/oder einem Ladezustand der Akku-Einheit des Haushaltsgerätes ermittelt werden. Ein Messen und/oder ein Ermitteln der Entladung erfolgt bevorzugt durch die Haushaltsgerätesteuerung oder die Akkueinheitssteuerung. Insbesondere kann der Ladezustand durch Messen des Innenwiderstands der Akku-Einheit ermittelt werden.

In einer Ausführungsform ist die Entladung eine aktuelle Entladung, also ein aktueller Wert während des Betriebs des Haushaltsgeräts. Eine Akku-Einheit, die an die Ladestation angeschlossen ist, kann also gemäß dieser Ausführungsform während des Betriebs des Haushaltsgeräts in Abhängigkeit von einer aktuellen Entladung einer Akku-Einheit, die zum Betrieb des Haushaltsgeräts zur Durchführung eines Benutzungsvorgangs an das Haushaltsgerät angeschlossen ist, geladen werden. Bei dieser Ausführungsform wird kontinuierlich oder in zeitlichen Intervallen während des Einsatzes der Akku-Einheit in dem Haushaltsgerät gemessen, wieviel elektrische Leistung pro Zeiteinheit bzw. pro Zeitintervall verbraucht wird, um in Abhängigkeit von diesem Messwert zu laden. Diese Ausführungsform ermöglicht besonders genau, dass die Akku-Einheit in der Ladestation oder mehrere Akku-Einheiten in einer oder mehreren Ladestationen so aufgeladen werden können, dass eine leere Akku-Einheit des Haushaltsgeräts ohne zeitliche Verzögerung gegen eine Akku-Einheit der Ladestation ersetzt werden kann, die zum Erzielen einer insgesamt quasi unendlichen Benutzungsdauer hinreichend aufgeladen ist. Da beim Ladevorgang in der Ladestation der aktuelle Energieverbrauch des Haushaltsgeräts in Form der aktuellen Entladung berücksichtigt wird, kann besonders zuverlässig das Haushaltsgerät zeitlich unbegrenzt genutzt werden.

In einer Ausführungsform steuert die Steuerung das Laden der Akku-Einheit der Ladestation derart, dass eine aktuelle Ladeleistung der Akku-Einheit der Ladestation der aktuellen Entladeleistung der sich im Betrieb befindlichen Akku-Einheit des Haushaltsgeräts entspricht oder gleich der aktuellen Entladeleistung der sich im Betrieb befindlichen Akku-Einheit des Haushaltsgeräts zuzüglich einer Verlustleistungskompensation ist. Eine kontinuierliche Einsatzbereitschaft des Haushaltsgeräts kann so besonders zuverlässig erzielt werden.

In einer Ausführungsform ermittelt und/oder misst das Haushaltsgerät, vorzugsweise eine Haushaltsgerätesteuerung, oder die Akku-Einheit des Haushaltsgeräts, vorzugsweise eine Akkueinheitssteuerung, die Entladeleistung und übermittelt die ermittelte Entladeleistung die Ladestation, damit die Akku-Einheit der Ladestation in Abhängigkeit von der aktuellen Entladeleistung geladen werden kann. Die aktuelle Ladeleistung kann dadurch annährend in Echtzeit an die aktuelle Entladeleistung angepasst werden. Durch diese Art Synchronisation kann eine kontinuierliche Einsatzbereitschaft besonders zuverlässig erzielt werden.

In einer Ausgestaltung ist vorgesehen, dass die Ladestation eine Ladestationssteuerung hat, das Hausgerät eine Haushaltsgerätesteuerung hat und/oder die Akku-Einheit eine Akkueinheitssteuerung hat. Dies ermöglicht eine besonders effiziente Datenerfassung und synergetische Datenverknüpfung, um besonders zuverlässig eine quasi unendliche Benutzungsdauer zu ermöglichen. Dazu kann ferner in einer Ausgestaltung eine Basisstation zum Laden der Akku-Einheit eines an die Basisstation angeschlossenen Haushaltsgerätes vorgesehen werden. Insbesondere ist die Basisstation mit einer Basisstationssteuerung ausgestattet. In einer Weiterentwicklung ist eine externe Rechnereinheit oder eine Schnittstelle dafür vom System umfasst. Insbesondere hat die externe Rechnereinheit eine Rechnersteuerung. Vorzugsweise ist die externe Rechnereinheit ein Smartphone oder Server, vorzugsweise mit einer App oder Cloud-Anwendung.

Erfindungsgemäß erfolgt die Steuerung durch die Ladestationssteuerung, die Haushaltsgerätesteuerung, die Akkueinheitssteuerung, die Basisstationssteuerung und/oder die Rechnersteuerung. In einer Ausgestaltung umfasst das für die Steuerung eingesetzte Gerät eine kabelgebundene und/oder drahtlose Kommunikationsschnittstelle.

In einer Ausführungsform ist die Entladung eine prognostizierte Entladung, also ein prognostizierter Wert. Eine Akku-Einheit, die an die Ladestation angeschlossen ist, kann somit in Abhängigkeit von einer prognostizierten Entladung einer Akku-Einheit, die zum Betrieb des Haushaltsgeräts zur Durchführung eines Benutzungsvorgangs an das Haushaltsgerät angeschlossen ist, geladen werden. Diese Ausführungsform ermöglicht mit geringem technischen Aufwand, eine quasi unendliche Benutzungsdauer mit einem besonders einfach aufgebauten System zu erzielen.

In einer Ausführungsform wird die prognostizierte Entladung auf Basis von einem Messen oder Ermitteln der Entladung von mindestens einem in der Vergangenheit durchgeführten Benutzungsvorgang ermittelt. Eine aufwändige Echtzeit-Erfassung und Übermittlung der aktuellen Entladung kann dadurch vermieden werden. Ein in der Vergangenheit durchgeführter Benutzungsvorgang ist ein abgeschlossener Vorgang wie z.B. die Fertigstellung der Bodenreinigung einer Wohnung, d.h., ohne zeitliche Überlappung mit einem anschließenden oder aktuellen Benutzungsvorgang.

In einer Ausgestaltung wird die Entladung während eines in der Vergangenheit durchgeführten Benutzungsvorgangs durch das Haushaltsgerät oder die Akku-Einheit gemessen oder ermittelt. In einer Ausführungsform speichert das Haushaltsgerät und/oder die Akku-Einheit die Daten über die Entladung, vorzugsweise einen Entladungsverlauf über die Zeit. In einer Ausgestaltung übermittelt das Haushaltsgerät, insbesondere die Haushaltsgerätesteuerung mit den gespeicherten Daten, die Daten an die Akku-Einheit, bevorzugt drahtgebunden. Alternativ kann vorgesehen sein, dass das Haushaltsgerät die Daten an eine Basisstation übermittelt, wenn das Haushaltsgerät an die Basisstation angeschlossen wird. Vorzugsweise leitet die Basisstation die Daten dann an die Ladestation weiter, bevorzugt drahtgebunden. In einer Ausgestaltung übermittelt die Akku-Einheit die gespeicherten Daten über die Entladung an die Ladestation, insbesondere drahtgebunden, wenn die Akku-Einheit an die Ladestation angeschlossen wird.

In einer Ausführungsform entspricht die prognostizierte Entladung der mittleren Entladung von mindestens einem in der Vergangenheit durchgeführten Benutzungsvorgang. Eine vergleichsweise einfache Berechnungsweise, die sehr wenig Rechenkapazität benötigt, kann dadurch genügen, um eine für den Ladevorgang hinreichend nutzbaren Wert der prognostizierten Entladung, also der Entladeleistung, bereitzustellen. Beispielsweise führen zudem Pausen während eines Benutzungsvorgangs dazu, dass die Entladeleistung im Mittel sinkt und somit auch die Ladeleistung reduziert werden kann. In einer Ausgestaltung ist die mittlere Entladung die durchschnittliche Entladeleistung, die während einem oder mehreren Benutzungsvorgängen gemessen oder ermittelt wurde. In einer Ausgestaltung ist die mittlere Entladung die durchschnittlich entnommene Energiemenge pro Benutzungsvorgang bei bekannter Benutzungsvorgangsdauer, d.h., die insgesamt entnommene Energiemenge während eines Benutzungsvorgangs mit bekannter Benutzungsvorgangsdauer. Vorzugsweise wird dabei über mehrere Benutzungsvorgänge der Vergangenheit gemittelt. Aus der entnommenen Energiemenge kann eine mittlere Entladung für einen definierten Benutzungsvorgang oder eine mittlere Entladeleistung ermittelt werden. In einer Ausgestaltung wird eine mittlere Entladung für unterschiedliche, definierte Benutzungsvorgänge ermittelt, z.B. Bodenreinigung der Wohnung oder Wandabsaugung der Wohnung. Insbesondere kann der Benutzungsvorgang durch die Haushaltsgeräteeinstellung automatisch zugeordnet werden.

In einer Ausführungsform wird die Entladeleistung anhand einer aktuelle Endladeleistung und einer prognostizierten Entladeleistung ermittelt. Eine besonders zuverlässige Funktionsweise kann so erhalten werden.

In einer Ausführungsform ist für genau oder jeweils eine Akku-Einheit des Haushaltsgerätes nur eine Akku-Einheit der Ladestation zum Ersetzen der einen Akku-Einheit des Haushaltsgerätes vorgesehen. Zusätzliche Ersatz-Akku-Einheiten werden vermieden. In einer Ausführungsform sind für genau oder jeweils eine Akku-Einheit des Haushaltsgerätes mindestens zwei Akku-Einheiten zum Ersetzen der einen Akku-Einheit des Haushaltsgerätes vorgesehen. Ein Verteilen des benötigten Ladungsumfangs auf die mindestens zwei Akku-Einheiten kann auf diese Weise umgesetzt werden. Dies ermöglicht ein Vermeiden oder Reduzieren eines beschleunigten Ladens. In einer Ausführungsform ist nur eine Akku-Einheit der mindestens zwei Akku-Einheiten an die Ladestation angeschlossen. Dies ermöglicht den Einsatz einer einfach aufgebauten Ladestation. In einer Ausführungsform sind die mindestens zwei Akku-Einheiten oder alle der mindestens zwei Akku-Einheiten an jeweils eine Ladestation oder an nur eine Ladestation angeschlossen. Dies ermöglicht die Auswertung der Zustände der einzelnen Akku-Einheiten, die an eine Ladestation angeschlossen sind.

In einer Ausführungsform ist die Steuerung so konfiguriert, dass die Entladung der Akku-Einheit des Haushaltsgerätes auf mehrere Akku-Einheiten aufgeteilt werden kann, derart, dass die mehreren Akku-Einheiten in Summe in dem Ladungsumfang geladen werden, die der Entladung der Akku-Einheit des Haushaltsgerätes entspricht oder die gleich der Entladung der Akku-Einheit des Haushaltsgerätes zuzüglich einer Verlustkompensation ist. Nach der Entleerung der Akku-Einheit des Haushaltsgerätes kann diese dann durch mindestens eine dieser mehreren Akku-Einheiten ersetzt werden. Die jeweiligen Zustände der einzelnen Akku-Einheiten beim Ladevorgang und bei der Auswahl zum Einsatz in dem Haushaltsgerät können so berücksichtigt werden. Insbesondere empfängt oder ermittelt die Ladestation, das Haushaltsgerät oder die Steuerung eine System-Grundinformation, eine System-Zustandsinformation, eine Akku-Einheit-Grundinformation einer Akku-Einheit und/oder eine Akku-Einheit-Zustandsinformation einer Akku-Einheit. Vorzugsweise erfolgen in Abhängigkeit von mindestens einer der vier genannten Informationen das Steuern des Ladens der Akku-Einheit der Ladestation und/oder ein Auswählen einer zu ladenden Akku-Einheit zum Ersetzen einer im Betrieb befindlichen Akku-Einheit des Haushaltsgeräts. Insbesondere kann auf einem Speicher einer Akku-Einheit die System-Grundinformation, System-Zustandsinformation, Akku-Einheit-Grundinformation und/oder Akku-Einheit-Zustandsinformation gespeichert werden.

Die Akku-Einheit-Grundinformation umfasst die Ladekapazität ab Auslieferung der Akku-Einheit vom Hersteller, den maximalen Ladestrom, die maximale Ladespannung ab Auslieferung vom Hersteller und/oder den Typ der Akku-Einheit, also das in der Akku-Einheit verwendete Batteriematerial wie z.B. Nickel-Kadmium (NiCd), Nickel-Metallhydrid (NiMH), Lithium-lon (Li-Ion) oder Lithium-Ion-Polymer (Li-lon-Poly). Die Akku-Einheit-Zustandsinformation umfasst den aktuellen Ladezustand der Akku-Einheit, die aktuelle Ladekapazität, den aktuellen Ladestrom, die aktuelle Ladespannung und/oder den aktuellen Innenwiderstand der Akkueinheit. In einer Ausgestaltung wird die Umgebungstemperatur gemessen. Die Ermittlung der Ladekapazität kann dann in Abhängigkeit von der Umgebungstemperatur erfolgen, um besonders präzise zu sein, weil die Ladekapazität mit fallender Temperatur sinkt. Die System-Grundinformation umfasst die Gesamtanzahl aller vom System umfassten Akku-Einheiten und/oder die Anzahl der Anschlüsse für Akku-Einheiten des Haushaltsgerätes und/oder der mindestens einen Ladestation. Die System-Zustandsinformation umfasst den Gesamtladezustand aller Akku-Einheiten, also die aktuell in allen Akku-Einheiten des Systems gespeicherte Gesamtenergiemenge inklusive der sich im Einsatz befindlichen Akku-Einheit und der nicht an ein Haushaltsgerät angeschlossenen Akku-Einheiten.

In einer Ausgestaltung erfolgt das Aufteilen der Entladung auf zwei Akku-Einheiten gleichzeitig, d.h., zeitgleich werden zwei Akku-Einheiten geladen, während die Akku-Einheit des Haushaltsgeräts entladen wird, die nach dessen Entleerung durch die zwei Akku-Einheiten ersetzt werden soll. Eine sich im Betrieb befindliche Akku-Einheit wird gemäß dieser Ausgestaltung also durch zwei Akku-Einheiten ersetzt. Beispielsweise kann so eine Akku-Einheit mit großer Ladekapazität durch zwei Ersatz-Akku-Einheiten mit jeweils einer altersbedingt geringen Ladekapazität ersetzt werden. In einer Ausgestaltung weist das Haushaltsgerät einen zusätzlichen Anschlussplatz auf, so dass für eine Akku-Einheit des Haushaltsgerätes, die für ein Ersetzen entnommen wurde, jeweils ein oder zwei Akku-Einheiten an das Haushaltsgerät an die Stelle der entnommenen Akku-Einheit angeschlossen werden kann. Nach dem Ersetzen einer Akku-Einheit durch zwei Akku-Einheiten werden zwei an das Haushaltsgerät angeschlossene Akku-Einheiten bevorzugt durch nur eine Akku-Einheit ersetzt, so dass ein Anschlussplatz wieder frei bleibt.

In einer Ausgestaltung erfolgt das Aufteilen der Entladung auf zwei Akku-Einheiten in zeitlich sukzessiver Weise. Wenn beispielsweise eine Akku-Einheit des Haushaltsgeräts eine große Ladekapazität und eine der mehreren Akku-Einheiten eine niedrige Ladekapazität aufweist, so kann die Akku-Einheit des Haushaltsgeräts zunächst durch die vollgeladene Akku-Einheit mit niedriger Ladekapazität ersetzt und die Differenz aus den unterschiedlichen Ladekapazitäten der als nächstes zu ladenden Akku-Einheit mit größerer Ladekapazität aufgeschlagen werden.

In einer Ausgestaltung werden eine Ladeobergrenze und/oder eine Entladeuntergrenze durch die Steuerung festgelegt und/oder gespeichert, vorzugsweise für jeden Entlade-Lade-Zyklus und/oder für jede Akku-Einheit. Auf diese Weise wird die Lebensdauer der Akku-Einheit erhöht. Zudem kann eine zeitlich sukzessive Verteilung der Entladung auf mehrere Akku-Einheiten vereinfacht werden. In einer Ausgestaltung werden die die Ladeobergrenze und/oder die Entladeuntergrenze in Abhängigkeit von einem ermittelten Verlust bzw. der Verlustkompensation, in Abhängigkeit von dem aktuellen Ladezustand, in Abhängigkeit von der aktuellen Ladekapazität und/oder in Abhängigkeit von der Umgebungstemperatur festgelegt. Die Berücksichtigung des aktuellen Ladezustands ermöglicht, dass die Lebensdauer einer Akku-Einheit erhöht wird, indem z.B. eine bereits nahezu voll geladene Akku-Einheit langsamer und eine leere Akku-Einheit schneller geladen wird. Die Berücksichtigung der aktuellen Ladekapazität ermöglicht ein entsprechendes Festlegen der Ladeobergrenze und/oder Entladeuntergrenze zum Ausgleich von altersbedingt unterschiedlicher Ladekapazitäten der Akku-Einheit, indem z.B. in einer Ausgestaltung die Entladeuntergrenze für eine eingesetzte Akku-Einheit mit geringerer aktueller Ladekapazität angehoben wird. Die Berücksichtigung der Umgebungstemperatur kann zur Korrektur ermittelten aktuellen Ladekapazität und/oder der Verlustkompensation dienen. Bei einer höheren Temperatur können z.B. die Verluste sinken und dadurch eine höhere Energiemenge entnommen werden. In einer Ausführungsform wird eine stärker gealterte Akku-Einheit schonender geladen als eine jüngere oder weniger stark gealterte Akku-Einheit. Insbesondere kann dazu alternativ oder ergänzend zur Ladeobergrenze oder Entladeuntergrenze ein Anpassen der Ladestromstärke oder der Ladespannung erfolgen. Eine Steuerung der Alterung der Akku-Einheiten kann so ermöglicht und dadurch die Lebensdauer der Akku-Einheiten erhöht werden.

In einer Ausführungsform wird der Benutzer aufgefordert, die eingesetzte Akku-Einheit gegen die Akku-Einheit in der Ladestation zu ersetzen, wenn die Akku-Einheit in der Ladestation eine Ladeobergrenze erreicht hat, also vollgeladen ist. Eine lebensdauerverkürzende Ladeerhaltung der sich in der Ladestation befindlichen vollgeladenen Akku-Einheit kann so vermieden werden.

Ein weiterer Aspekt der Erfindung betrifft ein Haushaltsgerät, insbesondere für das oben beschriebene System. Das Haushaltsgerät umfasst eine durch den Benutzer austauschbare Akku-Einheit zum Betreiben des Haushaltsgeräts sowie eine Haushaltsgerätesteuerung zum Steuern des Haushaltsgeräts. Das Haushaltsgerät ist so eingerichtet, dass eine Entladung der Akku-Einheit während der Durchführung eines Benutzungsvorgangs durch die Haushaltsgerätesteuerung und/oder eine Akkueinheitssteuerung der Akku-Einheit ermittelt und/oder an eine Ladestation oder eine Steuerung übermittelt werden kann. Durch das Ermitteln der Entladung, also der Entladeleistung, wird eine Eingangsgröße zur Ladung einer Akku-Einheit in einer Ladestation erhalten, was eine quasi unendliche Benutzungsdauer ermöglicht. Durch das Übermitteln kann ein besonders einfach aufgebautes System zur Erzielung einer quasi unendlichen Benutzungsdauer ermöglicht werden. Die Übermittlung kann unmittelbar im Anschluss an die Ermittlung in Echtzeit erfolgen oder, mithilfe einer Zwischenspeicherung, nach Abschluss des Benutzungsvorgangs. Der Inhalt der Beschreibung des eingangs beschriebenen Systems zur Lösung der Aufgabe einschließlich der Definitionen, Merkmale und Ausführungsformen ist auch auf diesen Aspekt der Erfindung anzuwenden.

Ein weiterer Aspekt der Erfindung betrifft eine Ladestation, insbesondere für das oben beschriebene System, zum Laden einer Akku-Einheit für ein Haushaltsgerät, d.h., die zum Anschließen und Betreiben eines Haushaltsgerätes eingerichtet ist. Die Ladestation ist so eingerichtet, dass die Ladestation eine Eingangsgröße, insbesondere eine Entladung, also eine Entladeleistung, einer Akku-Einheit eines Haushaltsgeräts, empfangen und in Abhängigkeit von der Eingangsgröße eine an die Ladestation angeschlossene Akku-Einheit laden kann. Der Inhalt der Beschreibung des eingangs beschriebenen Systems zur Lösung der Aufgabe einschließlich der Definitionen, Merkmale und Ausführungsformen ist auch auf diesen Aspekt der Erfindung anzuwenden.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben wird. Die beanspruchten Schutzbereiche sind nicht auf die Ausführungsbeispiele beschränkt. Es zeigen:
Figur 1: Schematische Darstellung einer Ladestation und eines Haushaltsgerätes;
Figur 2: Schematische Darstellung einer drahtlosen Übermittlung;
Figur 3: Schematische Darstellung einer Akku-Einheit;
Figur 4: Schematische Darstellung eines Lade- und Entladungsverlaufs.

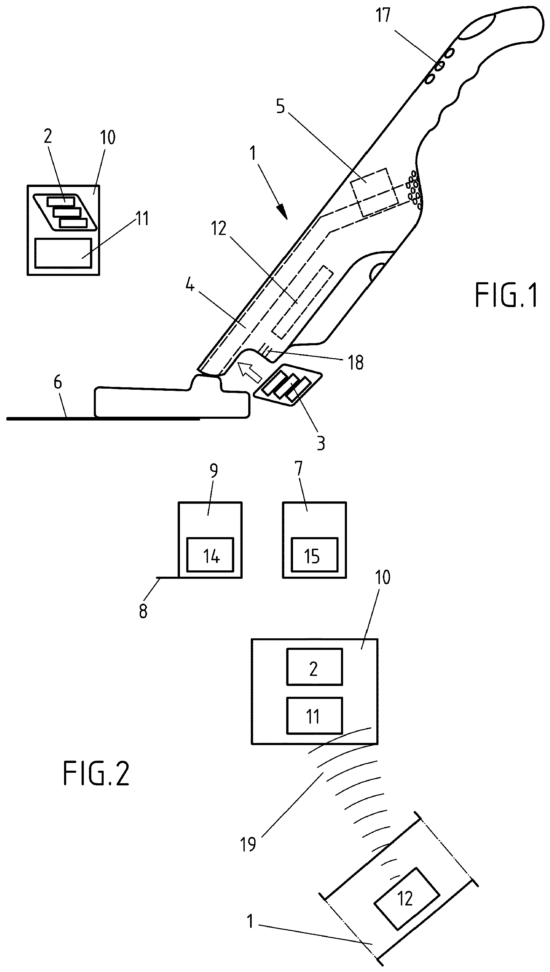

Die Figur 1 zeigt ein Beispiel eines Staubsaugers als das Haushaltsgerät 1, der mit Akku-Einheiten 2, 3 betrieben werden kann. Eine Akku-Einheit 3 kann vom Benutzer an einen Anschluss 18 des Haushaltsgeräts 1 angeschlossen und manuell austauscht werden. Zum Reinigen einer Oberfläche 6 kann Schmutz über ein wechselbares Vorsatzgerät von der Oberfläche 6 über einen Ansaugkanal 4 mithilfe eines Gebläses 5 des Haushaltsgerätes 1 angesaugt werden. Während das Haushaltsgerät 1 im Betrieb ist, kann durch eine entfernte Ladestation 10 eine Akku-Einheit 2, also eine Ersatz-Akku-Einheit, aufgeladen werden. Die Ladestation 10 hat eine Ladestationssteuerung 11 und ist über eine Steckdose an ein externes Stromnetz angeschlossen. Die Ladestation 10 ist daher grundsätzlich stationär zu betreiben, während das Haushaltsgerät 1 mobil und unabhängig von einem externen Stromnetz betrieben werden kann. Nach Abschluss der Durchführung eines Benutzungsvorgangs (hier: das Reinigen der Oberfläche 6), kann das Haushaltsgerät 1 an eine optional vorhandene Basisstation 9 mit einer Basisstationssteuerung 14 angeschlossen werden, welche die Akku-Einheit 3 des Haushaltsgerätes 1 über Stromleitungen des Haushaltsgerätes 1 laden kann. Eine externe Rechnereinheit 7 mit einer Rechnersteuerung 15 ist optional vorgesehen, um eine Benutzerschnittstelle zum Benutzer bereitzustellen und/oder den Ladevorgang der Akku-Einheiten 2, 3 zu steuern. Das Haushaltsgerät 1 ist mit einer Haushaltsgerätesteuerung 12 ausgestattet.

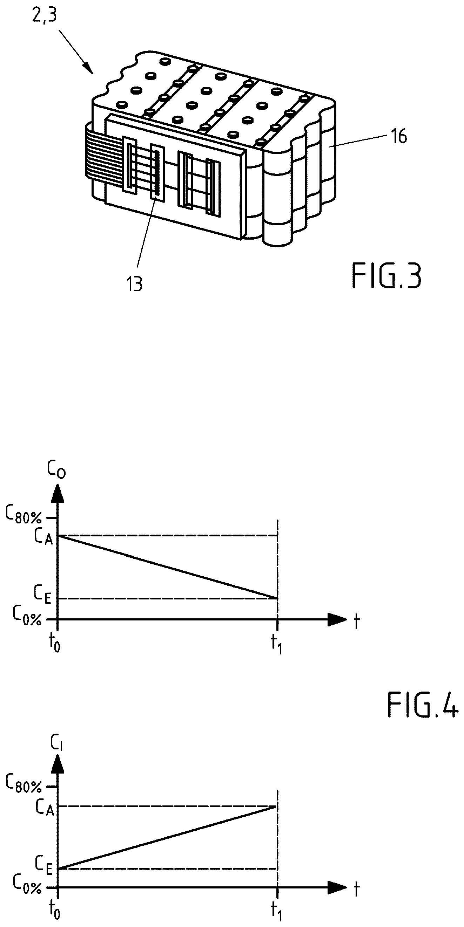

Die Figur 2 zeigt ein Ausführungsbeispiel, das zusätzlich zu dem Ausführungsbeispiel der Figur 1 eine drahtlose Verbindung 19 zum Austausch von Daten zwischen der Ladestationssteuerung 11 und der Haushaltsgerätesteuerung 12 illustriert. Die aktuelle Entladung der Akku-Einheit 3 wird bevorzugt in Echtzeit vom Haushaltsgerät 1 an die Ladestation 10 übermitteln. In einer Ausgestaltung sind die Akkueinheitssteuerung 13 (siehe Fig. 3), Basisstationssteuerung 14 und/oder Rechnersteuerung 15 für einen drahtlosen Datenaustausch eingerichtet. Die von mehreren Geräten ermittelten Daten können so miteinander verknüpft werden, um beispielsweise eine besonders geeignete Akku-Einheit 2 unter mehreren Akku-Einheiten 2, 3 zum Aufladen auszuwählen und/oder dem Benutzer zum Austausch für eine entleerte Akku-Einheit anzuzeigen.

Die Figur 3 zeigt eine Akku-Einheit 2, 3, die mit mindestens einem Akku 16 und einer Akkueinheitssteuerung 13 ausgestattet ist. In einer Ausgestaltung ist vorgesehen, dass der Ladevorgang gestoppt wird, wenn die Akku-Einheit 2 der Ladestation 10 vollgeladen bzw. die Ladeobergrenze erreicht ist, die zum Ersetzen der Akku-Einheit 3 des Haushaltsgeräts 1 vorgesehen ist. Ist der Ladevorgang gestoppt worden, so wird dies dem Benutzer über die Akku-Einheit 2, 3 des Haushaltsgeräts 1 oder der Ladestation 10, über die Ladestation 10, die Basisstation 9, das Haushaltsgerät 1, oder über die externe Rechnereinheit 7 angezeigt oder akustisch signalisiert, und zwar vorzugsweise mit der Anweisung oder Empfehlung an den Benutzer, die Akku-Einheit 2 zu ersetzen.

Die Figur 4 zeigt ein schematisches, vereinfachtes Beispiel für einen Entlade-Verlauf der Akku-Einheit 3 des Haushaltsgerätes 1 und einen entsprechenden Lade-Verlauf der Akku-Einheit 2 der Ladestation 10. Wie die Gegenüberstellung der Verläufe der beiden Akku-Einheiten 2, 3 in Figur 4 zeigt, verhält sich die Änderung des Ladezustands jeweils entgegengesetzt zueinander. Gleiches gilt auch für die Verläufe der Entladeleistung und Ladeleistung, die nicht dargestellt sind. Zur Vereinfachung wurden die Verläufe linear dargestellt. In Wirklichkeit schwankt die Entladeleistung und damit die Änderung des Ladezustands der Akku-Einheit 3 über die Zeit t während der Benutzung des Haushaltsgeräts 1 zum Teil erheblich. Bei einem Staubsauger steigt die Entladeleistung z.B. beim Übergang von einem glatten Boden zu einem Teppich sowie bei Umschalten in eine höhere Leistungsstufe. Entsprechend würde dann der Ladezustand C_{O} der Akku-Einheit 3 steiler abfallen. Beide Verläufe sind jeweils über die Zeit t für einen Entlade-Lade-Zyklus aufgetragen. Wie Figur 4, oben, zeigt, fällt der Ladezustand C_{O} der Akku-Einheit 3 des Haushaltsgerätes 1 infolge der Versorgung des Haushaltsgeräts 1 mit elektrischer Energie für den Benutzungsvorgang in dem Entladezeitraum t₀ bis t₁ von einem Ladezustand C_{A}, der bevorzugt als Ladeobergrenze für den vorangegangenen Ladezeitraum der Akku-Einheit 3 festgelegt wurde, auf einen Ladezustand C_{E} ab. Eine Ladeobergrenze ist bevorzugt gleich oder kleiner als ein Ladezustand C_{80%} von 80%. Der Ladezustand C_{E} ist bevorzugt eine festgelegte Entladeuntergrenze, die größer als ein Ladezustand C_{0%} von 0% ist. Der Ladezeitraum t₀ bis t₁ ist bevorzugt gleich lang wie der Entladezeitraum desselben Entlade-Lade-Zyklus und/oder zeitgleich dazu. In dem Ladezeitraum des gezeigten Entlade-Lade-Zyklus steigt der Ladezustand C_{I} der Akku-Einheit 2 der Ladestation 10 wie der Ladezustand C_{O} der Akku-Einheit 3 fällt. Dazu wird die Akku-Einheit 2 mit einer Ladeleistung geladen, die gleich der Entladeleistung der Akku-Einheit 3 zuzüglich einer Verlustkompensation ist. Wenn die aktuelle Entladeleistung sehr hoch ist und eine normale Ladegeschwindigkeit nicht ausreicht, um die benötigte Ladeleistung entsprechend der aktuellen Entladeleistung zuzüglich der Verlustkompensation zu erreichen, kann vorübergehend beschleunigt geladen werden, so dass stets zum Zeitpunkt t₂ der Ladezustand C_{A} erreicht ist, auf den auch die dann entleerte Akku-Einheit 3 zuvor aufgeladen worden war. Ist die aktuelle Entladeleistung entsprechend gering oder war die Akku-Einheit 2 in einem bereits teilweise geladenen Zustand an die Ladestation 10 angeschlossen worden, kann mit einer langsamen Ladegeschwindigkeit geladen werden.

In einer Ausführungsform ist die Akkueinheitssteuerung 13 ein Batterie-Management-System, auch BMS abgekürzt. Dies ermöglicht ein zuverlässiges Messen des aktuellen Ladezustands einer Akku-Einheit, der aktuellen Ladekapazität der Akku-Einheit, der Umgebungstemperatur und/oder einer Akku-Temperatur. Vorzugsweise ist das BMS in der Akku-Einheit integriert. In einer Ausgestaltung weist eine Akku-Einheit 2, 3 zusätzlich zu einem BMS einen zusätzlichen Speicher, z.B. Flash Speicher, und/oder eine (zusätzliche) Leistungsmesseinrichtung umfassen.

In einer Ausführungsform werden zur Messung der Entladeleistung zur Beschreibung und/oder Charakterisierung des Ladezustands oder des Lade- sowie Entladevorgangs eine Stromstärke, eine Spannung und/oder ein Innenwiderstand gemessen oder ermittelt. Auch auf die Verwendung elektromagnetischer oder elektrostatischer Größen wird in einer Ausgestaltung zur Bestimmung des Ladezustandes zurückgegriffen werden, z.B. magnetischer Fluss, elektromagnetische Kraft, Coulomb-Kraft, Lorentzkraft, elektromagnetische Flussdichte.

In einer Ausführungsform ist vorgesehen, dass innerhalb einer Schutzelektronik der Akkueinheitssteuerung 13 stets die aktuelle Spannung, also der Spannungsverlauf, sowie die aktuelle Stromstärke, also der Stromverlauf, erfasst werden. Eine Leistungsermittlung der Entladeleistung kann somit über der Zeit mithilfe des Akkueinheitssteuerung 13 erfolgen. Bevorzugt erfolgt ein Abgleich der Entladeleistung (Verlauf über die Zeit), der mittleren Entladeleistung oder entnommene Energiemenge des letzten Benutzungsvorgangs, des Widerstands oder der Ladezustandsveränderung mit vergangen Entladeprofilen vergangener Benutzungsvorgänge. Eine statistische Auswertung und eine optimierte Ladesteuerung kann so basierend auf einer Schätzung der zu erwartenden Entladeleistung (Verlauf über die Zeit), mittleren Entladeleistung oder benötigten Energiemenge des nächsten Zyklus ermöglicht werden. Es kann also die wahrscheinlich benötigte Entladeleistung (Verlauf über die Zeit), mittlere Entladeleistung oder benötigte Energiemenge ermittelt und für die Steuerung des Ladevorgangs genutzt werden.

In einer Ausgestaltung ist vorgesehen, dass ein Benutzer die oben beschriebene Funktion zum Laden einer Akku-Einheit 2 in Abhängigkeit von der Entladung einer eingesetzten Akku-Einheit 3 nach Bedarf aktivieren und deaktiviert kann, z.B. per App oder durch eine Wahlmöglichkeit, z.B. Schalter, an dem Haushaltsgerät oder einer Basisstation 9. Ob diese Konfiguration aktiv ist, kann dem Benutzer dann am Haushaltsgerät, an der Akku-Einheit 2, 3, an der Basisstation 9 oder der Rechnereinheit 7 per Anzeige, z.B. per LED 17, oder in einer App angezeigt werden.

## Patentansprüche

1. System mit einem Haushaltsgerät (1), einer Ladestation (10), einer durch den Benutzer austauschbaren Akku-Einheit (3) des Haushaltsgeräts (1), die zum Betrieb des Haushaltsgeräts (1) zur Durchführung eines Benutzungsvorgangs an das Haushaltsgerät (1) angeschlossen ist, und eine Akku-Einheit (2) der Ladestation (10), die zum Laden an die Ladestation (10) angeschlossen ist, wobei eine Steuerung (11, 12, 13, 14, 15) des Haushaltsgeräts (12), der Ladestation (11) oder der Akku-Einheiten (13) so konfiguriert ist, dass die Ladestation (10) die Akku-Einheit (2) der Ladestation (10) in Abhängigkeit von einer Entladung der Akku-Einheit (3) des Haushaltsgeräts (1) in einem Ladungsumfang lädt, welcher der Entladung der Akku-Einheit (2) des Haushaltsgeräts (1), die an die Steuerung übermittelt wird, zuzüglich einer Verlustkompensation entspricht, wobei die Verlustkompensation ein Wert größer Null zur Kompensation von energetischen Verlusten ist, die auftreten können, wenn die Akku-Einheit (3) des Haushaltsgeräts (1) um eine bestimmte Energie entladen wird, im Gegenzug die Akku-Einheit (2) der Ladestation (10) um dieselbe bestimmte Energie geladen wird und schließlich die Akku-Einheit (3) des Haushaltsgeräts (1) durch die Akku-Einheit (2) der Ladestation (10) ersetzt wird, und die Verlustkompensation durch die Steuerung (11, 12, 13, 14, 15) ermittelt wird oder in der Steuerung (11, 12, 13, 14, 15) hinterlegt ist.

2. System nach Anspruch 1, **dadurch gekennzeichnet, dass** die Akku-Einheit (2, 3) eine Akkueinheitssteuerung (13) umfasst und/oder die Steuerung (11, 12, 13, 14, 15) die Akkueinheitssteuerung (13) ist.

3. System nach Anspruch 2, **dadurch gekennzeichnet, dass** die Verlustkompensation in der Akkueinheitssteuerung (13) hinterlegt ist.

4. System nach einem der zwei vorhergehenden Ansprüche, **dadurch gekennzeichnet, dass** die Akkueinheitssteuerung (13) ein Batterie-Management-System, abgekürzt BMS, ist.

5. System nach einem der drei vorhergehenden Ansprüche, **dadurch gekennzeichnet, dass** die Akkueinheitssteuerung (13) zum Messen eines aktuellen Ladezustands der Akku-Einheit (2, 3) und/oder einer aktuellen Ladekapazität der Akku-Einheit (2, 3) eingerichtet ist.

6. System nach einem der vier vorhergehenden Ansprüche, **dadurch gekennzeichnet, dass** die Akkueinheitssteuerung (13) die Entladung ermittelt.

7. System nach Anspruch 6, **dadurch gekennzeichnet, dass** die Akkueinheitssteuerung (13) die Entladung anhand eines Ladezustands der Akku-Einheit (2) des Haushaltsgeräts (1) und/oder einer insgesamt entnommenen Energiemenge ermittelt.

8. System nach Anspruch 6 oder 7, **dadurch gekennzeichnet, dass** die Akkueinheitssteuerung (13) eine Spannung oder einen Innenwiderstand der Akku-Einheit (2, 3) misst und/oder unter Berücksichtigung dessen die Entladung ermittelt.

9. System nach einem der vorhergehenden Ansprüche, **dadurch gekennzeichnet, dass** das System so eingerichtet ist, dass Daten über die Entladung in der Akku-Einheit (2, 3) gespeichert werden, und/oder die in der Akku-Einheit (2, 3) gespeicherten Daten über die Entladung an die Ladestation (11) übermittelt werden, insbesondere drahtgebunden, wenn die Akku-Einheit an die Ladestation angeschlossen wird.

10. Akku-Einheit (3) für das System nach einem der vorhergehenden Ansprüche zum Versorgen eines Haushaltsgeräts (1) mit elektrischer Energie umfassend eine Akkueinheitssteuerung (13), insbesondere ein Batterie-Management-System, BMS, wobei die Akkueinheitssteuerung (13) so konfiguriert ist, dass die Akkueinheitssteuerung (13) eine Entladung der Akku-Einheit (3) zum Versorgen des Haushaltsgeräts (1) mit elektrischer Energie ermittelt und an eine Ladestation (10) übermittelt, der es damit ermöglicht werden kann, eine andere an die Ladestation (10) angeschlossene Akku-Einheit (2) in Abhängigkeit von der übermittelten Entladung in einem Ladungsumfang zu laden, welcher der Entladung der Akku-Einheit (3) des Haushaltsgeräts (1) zuzüglich einer Verlustkompensation entspricht,
wobei die Akkueinheitssteuerung (13) so konfiguriert ist, dass die Akkueinheitssteuerung (13) die Verlustkompensation ermittelt oder die Verlustkompensation in der Akkueinheitssteuerung (13) hinterlegt ist, wobei die Verlustkompensation ein Wert größer Null zur Kompensation von energetischen Verlusten ist, die auftreten können, wenn die Akku-Einheit (3) des Haushaltsgeräts (1) um eine bestimmte Energie entladen wird, im Gegenzug die Akku-Einheit (2) der Ladestation (10) um dieselbe bestimmte Energie geladen wird und schließlich die Akku-Einheit (3) des Haushaltsgeräts (1) durch die Akku-Einheit (2) der Ladestation (10) ersetzt wird.

11. Haushaltsgerät (1) umfassend eine durch den Benutzer austauschbare Akku-Einheit (3) zum Betreiben des Haushaltsgeräts (1) sowie eine Haushaltsgerätesteuerung (12) zum Steuern des Haushaltsgeräts (1), wobei das Haushaltsgerät (1) so eingerichtet ist, dass eine Entladung der Akku-Einheit (3) während der Durchführung eines Benutzungsvorgangs durch die Haushaltsgerätesteuerung (12) ermittelt und an eine Ladestation (10) übermittelt wird, der es damit ermöglicht werden kann, eine andere an die Ladestation (10) angeschlossene Akku-Einheit (2) in Abhängigkeit von der übermittelten Entladung der Akku-Einheit (3), die zum Betrieb des Haushaltsgeräts (1) zur Durchführung eines Benutzungsvorgangs an das Haushaltsgerät (1) angeschlossen ist, in einem Ladungsumfang zu laden, welcher der Entladung der Akku-Einheit (2) des Haushaltsgeräts (1) zuzüglich einer Verlustkompensation entspricht,
wobei die Haushaltsgerätesteuerung (12) so konfiguriert ist, dass die Haushaltsgerätesteuerung (12) die Verlustkompensation ermittelt oder die Verlustkompensation in der Haushaltsgerätesteuerung (12) hinterlegt ist, wobei die Verlustkompensation ein Wert größer Null zur Kompensation von energetischen Verlusten ist, die auftreten können, wenn die Akku-Einheit (3) des Haushaltsgeräts (1) um eine bestimmte Energie entladen wird, im Gegenzug die Akku-Einheit (2) der Ladestation (10) um dieselbe bestimmte Energie geladen wird und schließlich die Akku-Einheit (3) des Haushaltsgeräts (1) durch die Akku-Einheit (2) der Ladestation (10) ersetzt wird.

## Claims

1. System comprising a household appliance (1), a charging station (10), a battery unit (3) of the household appliance (1) which is exchangeable by the user and which is connected to the household appliance (1) for operating the household appliance (1) in order to carry out a use operation, and a battery unit (2) of the charging station (10) which is connected to the charging station (10) for charging, wherein a controller (11, 12, 13, 14, 15) of the household appliance (12), of the charging station (11) or of the battery units (13) is configured such that the charging station (10) charges the battery unit (2) of the charging station (10) as a function of a discharge of the battery unit (3) of the household appliance (1) by a charge amount which corresponds to the discharge of the battery unit (2) of the household appliance (1), which is transmitted to the controller, plus a loss compensation, wherein the loss compensation is a value greater than zero for compensating energy losses which may occur if the battery unit (3) of the household appliance (1) is discharged by a particular amount of energy, in return the battery unit (2) of the charging station (10) is charged by the same particular amount of energy and finally the battery unit (3) of the household appliance (1) is replaced by the battery unit (2) of the charging station (10), and the loss compensation is determined by the controller (11, 12, 13, 14, 15) or is stored in the controller (11, 12, 13, 14, 15).

2. System according to claim 1, **characterised in that** the battery unit (2, 3) comprises a battery unit controller (13) and/or the controller (11, 12, 13, 14, 15) is the battery unit controller (13).

3. System according to claim 2, **characterised in that** the loss compensation is stored in the battery unit controller (13).

4. System according to one of the two preceding claims, **characterised in that** the battery unit controller (13) is a battery management system, abbreviated to BMS.

5. System according to one of the three preceding claims, **characterised in that** the battery unit controller (13) is configured to measure a current state of charge of the battery unit (2, 3) and/or a current charging capacity of the battery unit (2, 3).

6. System according to one of the four preceding claims, **characterised in that** the battery unit controller (13) determines the discharge.

7. System according to claim 6, **characterised in that** the battery unit controller (13) determines the discharge on the basis of a state of charge of the battery unit (2) of the household appliance (1) and/or of a total amount of energy drawn.

8. System according to claim 6 or 7, **characterised in that** the battery unit controller (13) measures a voltage or an internal resistance of the battery unit (2, 3) and/or determines the discharge taking this into account.

9. System according to one of the preceding claims, **characterised in that** the system is configured such that data on the discharge are stored in the battery unit (2, 3), and/or the data on the discharge stored in the battery unit (2, 3) are transmitted to the charging station (11), in particular in a wired manner, when the battery unit is connected to the charging station.

10. Battery unit (3) for the system according to one of the preceding claims, for supplying a household appliance (1) with electrical energy, comprising a battery unit controller (13), in particular a battery management system, BMS, wherein the battery unit controller (13) is configured such that the battery unit controller (13) determines a discharge of the battery unit (3) for supplying the household appliance (1) with electrical energy and transmits it to a charging station (10), which can thereby be enabled to charge another battery unit (2) connected to the charging station (10), as a function of the transmitted discharge, by a charge amount which corresponds to the discharge of the battery unit (3) of the household appliance (1) plus a loss compensation,
wherein the battery unit controller (13) is configured such that the battery unit controller (13) determines the loss compensation or the loss compensation is stored in the battery unit controller (13), wherein the loss compensation is a value greater than zero for compensating energy losses which may occur if the battery unit (3) of the household appliance (1) is discharged by a particular amount of energy, in return the battery unit (2) of the charging station (10) is charged by the same particular amount of energy and finally the battery unit (3) of the household appliance (1) is replaced by the battery unit (2) of the charging station (10).

11. Household appliance (1) comprising a battery unit (3) which is exchangeable by the user, for operating the household appliance (1), and a household appliance controller (12) for controlling the household appliance (1), wherein the household appliance (1) is configured such that a discharge of the battery unit (3) during the performance of a use operation is determined by the household appliance controller (12) and transmitted to a charging station (10), which can thereby be enabled to charge another battery unit (2) connected to the charging station (10), as a function of the transmitted discharge of the battery unit (3) which is connected to the household appliance (1) for operating the household appliance (1) in order to carry out a use operation, by a charge amount which corresponds to the discharge of the battery unit (2) of the household appliance (1) plus a loss compensation,
wherein the household appliance controller (12) is configured such that the household appliance controller (12) determines the loss compensation or the loss compensation is stored in the household appliance controller (12), wherein the loss compensation is a value greater than zero for compensating energy losses which may occur if the battery unit (3) of the household appliance (1) is discharged by a particular amount of energy, in return the battery unit (2) of the charging station (10) is charged by the same particular amount of energy and finally the battery unit (3) of the household appliance (1) is replaced by the battery unit (2) of the charging station (10).

## Revendications

1. Système comprenant un appareil ménager (1), une station de recharge (10), une unité de batterie (3) de l'appareil ménager (1) pouvant être remplacée par l'utilisateur, qui est connectée à l'appareil ménager (1) pour permettre son fonctionnement en vue de l'exécution d'une opération d'utilisation, et d'une unité de batterie (2) de la station de recharge (10), qui est connectée à la station de recharge (10) pour être rechargée, un système de commande (11, 12, 13, 14, 15) de l'appareil ménager (12), de la station de recharge (11) ou des unités de batterie (13) étant configurée de telle sorte que la station de recharge (10) recharge l'unité de batterie (2) de la station de recharge (10) en fonction d'une décharge de l'unité de batterie (3) de l'appareil ménager (1) en fonction d'un niveau de décharge de l'unité de batterie (2) de l'appareil ménager (1), qui est transmise au système de commande, majorée d'une compensation de perte, la compensation de perte étant une valeur supérieure à zéro destinée à compenser les pertes énergétiques pouvant survenir lorsque l'unité de batterie (3) de l'appareil ménager (1) est déchargée d'une quantité d'énergie déterminée, en contrepartie, l'unité de batterie (2) de la station de recharge (10) est chargée de cette même quantité d'énergie déterminée et, enfin, l'unité de batterie (3) de l'appareil ménager (1) est remplacée par l'unité de batterie (2) de la station de recharge (10), et la compensation des pertes est déterminée par le système de commande (11, 12, 13, 14, 15) ou est enregistrée dans le système de commande (11, 12, 13, 14, 15).

2. Système selon la revendication 1, **caractérisé en ce que** l'unité de batterie (2, 3) comprend un système de commande d'unité de batterie (13) et/ou **en ce que** le système de commande (11, 12, 13, 14, 15) est le système de commande de l'unité de batterie (13).

3. Système selon la revendication 2, **caractérisé en ce que** la compensation des pertes est intégrée dans le système de commande de l'unité de batterie (13).

4. Système selon l'une des deux revendications précédentes, **caractérisé en ce que** le système de commande de l'unité de batterie (13) est un système de gestion de batterie, abrégé BMS.

5. Système selon l'une des trois revendications précédentes, **caractérisé en ce que** le système de commande de batterie (13) est conçue pour mesurer un état de charge actuel de l'unité de batterie (2, 3) et/ou une capacité de charge actuelle de l'unité de batterie (2, 3).

6. Système selon l'une des quatre revendications précédentes, **caractérisé en ce que** le système de commande de l'unité de batterie (13) détermine la décharge.

7. Système selon la revendication 6, **caractérisé en ce que** le système de commande de l'unité de batterie (13) détermine la décharge à partir d'un état de charge de l'unité de batterie (2) de l'appareil ménager (1) et/ou d'une quantité totale d'énergie prélevée.

8. Système selon la revendication 6 ou 7, **caractérisé en ce que** le système de commande de l'unité de batterie (13) mesure une tension ou une résistance interne de l'unité de batterie (2, 3) et/ou détermine la décharge en tenant compte de celle-ci.

9. Système selon l'une des revendications précédentes, **caractérisé en ce que** le système est agencé de telle sorte que des données relatives à la décharge soient enregistrées dans l'unité de batterie (2, 3), et/ou que les données relatives à la décharge stockées dans l'unité de batterie (2, 3) soient transmises à la station de charge (11), notamment par câble, lorsque l'unité de batterie est connectée à la station de charge.

10. Unité de batterie (3) pour le système selon l'une des revendications précédentes, destinée à alimenter un appareil ménager (1) en énergie électrique, comprenant un système de commande d'unité de batterie (13), en particulier un système de gestion de batterie, BMS, le système commande d'unité de batterie (13) étant configurée de telle sorte que le système de commande d'unité de batterie (13) détecte une décharge de l'unité de batterie (3) destinée à alimenter l'appareil ménager (1) en énergie électrique et la transmette à une station de charge (10), ce qui permet à celle-ci de de charger une autre unité de batterie (2) raccordée à la station de charge (10), en fonction de la décharge transmise, à un niveau de charge correspondant à la décharge de l'unité de batterie (3) de l'appareil ménager (1) majorée d'une compensation des pertes,
le système de commande de l'unité de batterie (13) étant configurée de telle sorte que le système de commande de l'unité de batterie (13) détermine la compensation des pertes ou que celle-ci soit enregistrée dans le système de commande de l'unité de batterie (13), la compensation des pertes étant une valeur supérieure à zéro destinée à compenser les pertes d'énergie pouvant survenir lorsque l'unité de batterie (3) de l'appareil ménager (1) est déchargée d'une certaine quantité d'énergie, tandis que, parallèlement, l'unité de batterie (2) de la station de charge (10) est chargée de cette même quantité d'énergie et que, finalement, l'unité de batterie (3) de l'appareil ménager (1) est remplacée par l'unité de batterie (2) de la station de charge (10).

11. Appareil ménager (1) comprenant une unite de batterie (3) remplaçable par l'utilisateur pour faire fonctionner l'appareil ménager (1), ainsi qu'un système de commande (12) destinée à commander l'appareil ménager (1), l'appareil ménager (1) étant agencé de telle sorte qu'une décharge de l'unité de batterie (3) pendant l'exécution d'une opération d'utilisation soit détectée par le système de commande (12) et transmise à une station de charge (10), ce qui permet à celle-ci de charger une autre unité de batterie (2) raccordée à la station de charge (10) en fonction de la décharge transmise de l'unité de batterie (3) qui est connectée à l'appareil ménager (1) pour permettre à celui-ci d'effectuer une opération d'utilisation, à un niveau de charge correspondant à la décharge de l'unité de batterie (2) de l'appareil ménager (1) majorée d'une compensation de perte,
le système de commande de l'appareil ménager (12) étant configurée de telle sorte que ly système de commande de l'appareil ménager (12) détermine la compensation des pertes ou que celle-ci soit enregistrée dans le système de commande de l'appareil ménager (12), la compensation des pertes étant une valeur supérieure à zéro destinée à compenser les pertes d'énergie pouvant survenir lorsque l'unité de batterie (3) de l'appareil ménager (1) est déchargée d'une quantité d'énergie déterminée, tandis que, en contrepartie, l'unité de batterie (2) de la station de charge (10) est chargée de cette même quantité d'énergie déterminée et que, finalement, l'unité de batterie (3) de l'appareil ménager (1) est remplacée par l'unité de batterie (2) de la station de charge (10).
